# EUROPÄISCHE PATENTSCHRIFT

(11) **EP 1 093 325 B1**
(45) Veröffentlichungstag und Bekanntmachung des Hinweises auf die Patenterteilung: **01.03.2006**
(21) Anmeldenummer: 00120064.1
(22) Anmeldetag: 15.09.2000
(51) Int. Cl.: H05K 1/14, H01R 12/06, H05K 3/30, H05K 1/11, H01R 12/32

(54) **Mehrschichtige Anordnung mit elektrischen Kontaktstiften**
Multilayer assembly with electrical connection pins
Assemblage multicouche à broches de connexion électrique

(30) Priorität: 12.10.1999 DE 19949141
(43) Veröffentlichungstag der Anmeldung: 18.04.2001
(73) Patentinhaber: ROBERT BOSCH GMBH, 70442 Stuttgart (DE)
(72) Erfinder: Kazmierczak, Harald, 71717 Beilstein (DE)
(74) Vertreter: Hörschler, Wolfram Johannes

(56) Entgegenhaltungen:
- EP-A- 0 765 110
- DE-A- 2 807 874
- DE-A- 4 125 018

## Beschreibung

Die Erfindung betrifft eine Multilayer-Anordnung für eine Schaltungsplatine, insbesondere für die Zentralelektrik eines Kraftfahrzeugs, entsprechend dem Oberbegriff des Anspruchs 1.

### Stand der Technik

Aus der DE 195 35 490 A1 ist eine Schaltungsplatine bekannt, die Kontaktstifte zum elektrischen Kontaktieren mindestens einer Leiterplatte aufweist. Hierbei durchdringen die Kontaktstifte die Multilayer-Anordnung der bekannten Schaltungsplatine vollständig. Demzufolge steht der Austrittsbereich der Kontaktstifte der Multilayer-Anordnung nicht für eine Bestückung, insbesondere für einen weiteren Kontaktstift oder die Beinchen anderer elektronischer Bauelemente, wie beispielsweise Sicherungen oder Stecker, zur Verfügung.

Aus DE 28 07 874 A1 ist eine Mehrlagenverbindungsplatte aus übereinander angeordneten, doppelt kaschierten Leiterplatten bekannt. Diese sind durch Isolierschichten voneinander getrennt und weisen metallisierte Löcher auf, durch welche sich Anschlussstifte erstrecken. Als Isolierschichten sind dünne Folien vorgesehen, die von den in die Löcher einschiebbaren Anschlussstiften durchstoßbar sind.

DE 41 25 018 A1 bezieht sich auf eine elektrische Verbindung insbesondere zur Durchkontaktierung einer Leiterplatte. Bei den Leiterplatten handelt es sich um Mehrlagen-Leiterplatten(Multilayer), wobei die elektrische Verbindung von einem quer zu den Schichten verlaufenden, diese kontaktierenden elektrischen Verbindungsweg gebildet wird. Der elektrische Verbindungsweg wird von einem separat hergestellten und dann in die Leiterplatte eingebrachten leitenden Verbindungsteil gebildet, welches mit den Schichten verschweißt ist.

Aufgabe der vorliegenden Erfindung ist es, eine platzsparende Multilayer-Anordnung der im Oberbegriff des Anspruchs 1 genannten Art zu schaffen.

Gelöst wird dies Aufgabe erfindungsgemäß mit dem Gegenstand des Anspruchs 1. Vorteilhafte Ausgestaltungen des erfindungsgemäßen Gegenstands sind in den Unteransprüchen 2 bis 6 ausgeführt.

### Vorteile der Erfindung

Die Kontaktstifte sind erfindungsgemäß kürzer ausgebildet, so daß sie eine oder mehrere Leiterplatten der Multilayer-Anordnung kontaktieren und innerhalb der Multilayer-Anordnung enden. Dadurch steht der dem Eintrittsbereich des Kontaktstiftes in der Multilayer-Anordnung gegenüberliegende Bereich für eine platzsparende Bestückung der Multilayer-Anordnung bzw. Schaltungsplatine in vorteilhafter Weise zur Verfugung. Hierdurch kann bei vorgegebener Abmessung der Multilayer-Anordnung eine größere Anzahl von Kontaktstiften bzw. von Beinchen von elektronischen Bauelementen wie Sicherungen, Steckern etc. untergebracht werden. Anders ausgedrückt: Bei vorgegebener Anzahl von Kontaktstiften kann die Abmessung der Multilayer-Anordnung verringert werden.

Durch die kürzere Ausbildung der Kontaktstifte und eine Verringerung der Abmessungen der Multilayer-Anordnung kann Material gespart werden. Dies ist besonders bei der Verwendung hochwertiger Materialien, z.B. Gold für die Kontaktstifte, ein kostensparender Faktor.

Beim Einbringen der bekannten Kontaktstifte, die jeweils alle Leiterplatten der Multilayer-Anordnung durchgreifen, müssen jeweils in allen Leiterplatten Stanzlöcher vorgesehen werden. Um eine Kontaktierung der Kontaktstifte an den nicht zu kontaktierenden Leiterplatten zu verhindern, werden die Stanzlöcher in diesen Leiterplatten vergrößert ausgebildet. Diese Präparation der von den erfindungsgemäß kürzeren Kontaktstiften nicht durchgriffenen Leiterplatten entfällt.

Um bei den erfindungsgemäß kürzeren Kontaktstiften die Gefahr des Lösens des Kontaktstiftes aus der Multilayer-Anordnung bei äußerer Krafteinwirkung, insbesondere beim Beschleunigen oder beim Abbremsen eines Kraftfahrzeuges, zu verringern, sind gemäß der Erfindung die Anschlußfahnen der Kontaktstifte entsprechend der Eindringtiefe der Kontaktstifte in die Multilayer-Anordnung dimensioniert, d.h. bei den erfindungsgemäßen kürzeren Kontaktstiften sind kürzere Anschlußfahnen vorgesehen.

In einer weiteren bevorzugten Ausführungsform sind die Kontaktstifte mittels einer allgemein bekannten Einpreßtechnik in die Multilayer-Anordnung eingepreßt, was ebenfalls einen sicheren Halt der Kontaktstifte in der Multilayer-Anordnung garantiert.

Die Leiterplatten der Multilayer-Anordnung sind vorzugsweise Kupfer-Stanzplatten, die mit den Isolierschichten abwechselnd angeordnet sind. Die Isolierschichten können aus jedem Material, welches elektrisch isolierend wirkt, z.B. aus Kunststoff, hergestellt sein. Vorzugsweise werden elektrisch isolierende Klebefolien verwendet, die über ihre Isolierfunktion hinaus auch die verschiedenen, übereinander angeordneten Leiterplatten und gleichzeitig nebeneinander angeordnete Stanzsegmente zu einem Verbund vereinigen.

### Zeichnung

In der Zeichnung ist eine bevorzugte Ausführungsform der Multilayer-Anordnung dargestellt, die in der nachfolgenden Beschreibung näher erläutert ist. Es zeigen:
- Fig. 1: eine schematische Querschnittansicht einer Multilayer-Anordnung gemäß dem Stand der Technik; und
- Fig. 2: eine schematische Querschnittansicht einer Multilayer-Anordnung gemäß der Erfindung.

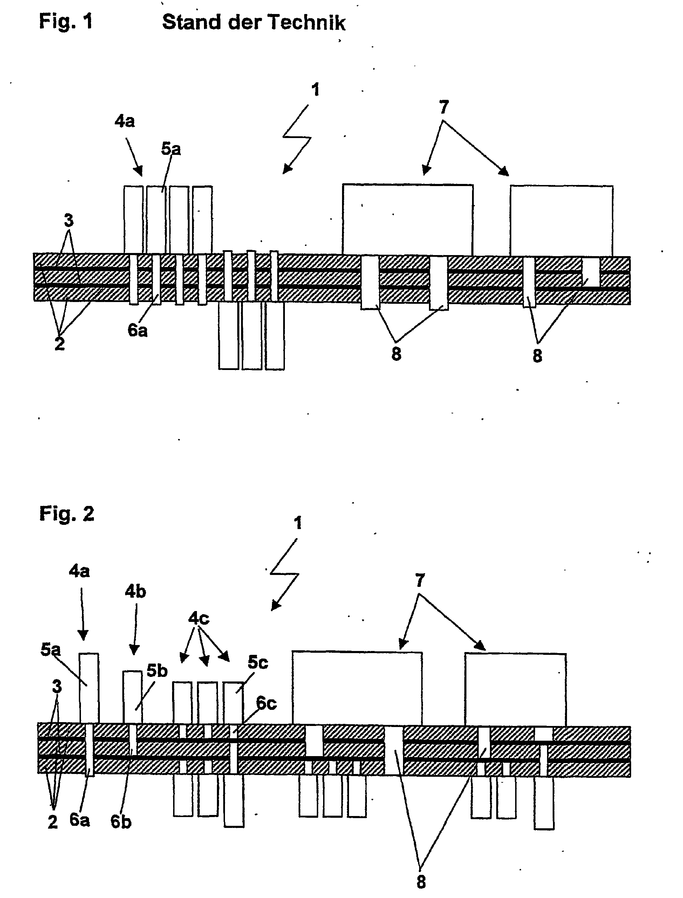

In Fig. 1 ist eine aus dem Stand der Technik bekannte Multilayer-Anordnung 1 schematisch im Querschnitt dargestellt, welche drei Leiterplatten 2 und jeweils zwischen den Leiterplatten 2 angeordnete Isolierschichten 3 aufweist. In der Multilayer-Anordnung 1 sind beidseitig Kontaktstifte 4a angeordnet, welche jeweils sämtliche Leiterplatten 2 der Multilayer-Anordnung 1 durchgreifen bzw. an den gegenüberliegenden Oberflächen der Multilayer-Anordnung 1 austreten. Die Kontaktstifte 4a weisen aus der Multilayer-Anordnung herausragende Anschlußfahnen 5a und in der Multilayer-Anordnung aufgenommene Stifte 6a auf. Weiterhin sind in Fig. 1 elektronische Bauelemente 7 schematisch dargestellt, welche mit ihren Beinchen 8 in der Multilayer-Anordnung 1 aufgenommen sind und räumlich getrennt von den Kontaktstiften 4a angeordnet sind.

Figur 2 zeigt schematisch eine Querschnittansicht der erfindungsgemäßen Multilayer-Anordnung 1. Die Leiterplatten 2 und Isolierschichten 3 sind entsprechend denen der Fig. 1 angeordnet. Die Kontaktstifte 4b und 4c zeigen verkürzte Stifte 6b, 6c, die jeweils nur zwei bzw. eine Leiterplatte 2 durchgreifen, so daß Paare von Kontaktstiften 4b, 4c auf direkt gegenüberliegenden Oberflächen der Multilayer-Anordnung 1 angebracht werden können. Die Anschlußfahnen 5b, 5c sind entsprechend der Eindringtiefe der Stifte 6b, 6c verkleinert. Eine platzsparende Bestückung der Multilayer-Anordnung 1 mit elektronischen Bauelementen 7, welche direkt gegenüberliegend zu den verkürzten Kontaktstiften 4b, 4c angeordnet sind, geht ebenfalls aus Fig. 2 hervor.

Bei einem angespitzten Stift (nicht dargestellt) kann in der nicht zu kontaktieren den Leiterplatte, welche sich an das angespitzte Ende des Stifts anschließt, ein Loch vorgesehen werden, um ein unbeabsichtigtes Kontaktieren dieser Leiterplatte sicher zu vermeiden.

## Patentansprüche

1. Multilayer-Anordnung (1) mit Kontaktstiften (4b, 4c), insbesondere für eine Schaltungsplatine für die Zentralelektrik eines Kraftfahrteuges, aus mindestens zwei Leiterplatten (2) und mindestens einer Isolierschicht (3) mit beidseitig angeordneten Kontaktstiften (4b, 4c), *wobei* mindestens einer der Kontaktstifte (4b, 4c) innerhalb der Multilayer-Anordnung (1) endet und mindestens eine Leiterplatte (2) kontaktiert, **dadurch gekennzeichnet, dass** die Kontaktstifte (4b, 4c) in der Multilayer-Anordnung (1) aufgenommene Stifte (6b, 6c) und Anschlussfahnen (5b, 5c) aufweisen, die entsprechend der Eindringtiefe der Kontaktstifte (4b, 4c) in die Multilayer-Anordnung (1) dimensioniert sind und an der Multilayer-Anordnung (1) auf einander gegenüberliegenden Seiten bestückbar sind.

2. Multilayer-Anordnung (1) nach Anspruch 1, **dadurch gekennzeichnet, dass** die Kontaktstifte (4b, 4c) in die Multilayer-Anordnung (1) eingepresst sind.

3. Multilayer-Anordnung (1) nach einem der Ansprüche 1 oder 2, **dadurch gekennzeichnet, dass** die Leiterplatten (2) aus Kupfer sind.

4. Multilayer-Anordnung (1) nach einem der Ansprüche 1 bis 3, **dadurch gekennzeichnet, dass** die Leiterplatten (2) Stanzplatten sind.

5. Multilayer-Anordnung (1) nach einem der Ansprüche 1 bis 4, **dadurch gekennzeichnet, dass** die Isolierschichten (3) Folien, insbesondere Klebefolien sind.

## Claims

1. Multilayer assembly (1) with contact pins (4b, 4c), in particular for a printed wiring board for the central electrics of a motor vehicle, comprising at least two circuit boards (2) and at least one insulating layer (3) with contact pins (4b, 4c) arranged on both sides, at least one of the contact pins (4b, 4c) ending within the multilayer assembly (1) and contacting at least one circuit board (2), **characterized in that** the contact pins (4b, 4c) have pins (6b, 6c) accommodated in the multilayer assembly (1) and terminal lugs (5b, 5c), which are dimensioned in accordance with the depth of penetration of the contact pins (4b, 4c) in the multilayer assembly (1) and can be fitted with components at the multilayer assembly (1) on sides lying opposite one another.

2. Multilayer assembly (1) according to Claim 1, **characterized in that** the contact pins (4b, 4c) are pressed into the multilayer assembly (1).

3. Multilayer assembly (1) according to either of Claims 1 and 2, **characterized in that** the circuit boards (2) are made of copper.

4. Multilayer assembly (1) according to one of Claims 1 to 3, **characterized in that** the circuit boards (2) are stamped boards.

5. Multilayer assembly (1) according to one of Claims 1 to 4, **characterized in that** the insulating layers (3) are films, in particular adhesive films.

## Revendications

1. Système multicouche (1) muni de fiches de contact (4b, 4c), en particulier pour une plaque à circuits imprimés destinée au système électrique central d'un véhicule automobile, composé d'au moins deux cartes imprimées (2) et d'au moins une couche isolante (3), comportant des fiches de contact (4b, 4c) placées de chaque côté, au moins une des fiches de contact (4b, 4c) se terminant à l'intérieur du système multicouche (1) et établissant le contact avec au moins une carte imprimée (2),
**caractérisé en ce que**
les fiches de contact (4b, 4c) comportent des fiches (6b, 6c) et des barrettes de raccordement (5b, 5c), logées dans le système multicouche (1), dont les dimensions correspondent à la profondeur à laquelle pénètrent les fiches de contact (4b, 4c) dans le système multicouche (1) et qui peuvent être disposées sur le système multicouche (1) sur des côtés opposés.

2. Système multicouche (1) selon la revendication 1,
**caractérisé en ce que**
les fiches de contact (4b, 4c) sont enfoncées dans le système multicouche (1).

3. Système multicouche (1) selon l'une des revendications 1 ou 2,
**caractérisé en ce que**
les cartes imprimées (2) sont en cuivre.

4. Système multicouche (1) selon l'une des revendications 1 à 3,
**caractérisé en ce que**
les cartes imprimées (2) sont des plaques estampées.

5. Système multicouche (1) selon l'une des revendications précédentes,
**caractérisé en ce que**
les couches isolantes (3) sont des feuilles, en particulier des feuilles adhésives.
